# EUROPEAN PATENT APPLICATION

(11) **EP 4 101 827 A1**
(43) Date of publication of application: **14.12.2022**
(21) Application number: 21781621.4
(22) Date of filing: 26.03.2021
(51) Int. Cl.: C04B 35/495, C01G 33/00, H01L 41/09, H01L 41/187

(54) **PIEZOELECTRIC CERAMIC COMPOSITION AND PIEZOELECTRIC ACTUATOR**

(30) Priority: 30.03.2020 JP 2020060390
(71) Applicant: Kyocera Corporation, Kyoto-shi Kyoto 612-8501 (JP)
(72) Inventor: HIRAYAMA, Takeshi, Kyoto-shi, Kyoto 612-8501 (JP); TABATA, Shuhei, Kyoto-shi, Kyoto 612-8501 (JP); HIGASHIBEPPU, Makoto, Kyoto-shi, Kyoto 612-8501 (JP); SHIMURA, Gen, Kyoto-shi, Kyoto 612-8501 (JP); HASEGAWA, Yukihiro, Kyoto-shi, Kyoto 612-8501 (JP)
(74) Representative: Viering, Jentschura & Partner mbB Patent- und Rechtsanwälte
(86) International application number: PCT/JP2021/012805
(87) International publication number: WO 2021/200632

(57) **Abstract**

Provided is a piezoelectric ceramic composition including a potassium sodium niobate-based perovskite type complex oxide represented by Compositional Formula ABO₃, as a main component. Further, the piezoelectric ceramic composition contains Bi in an A site and Zr in a B site. Further, the piezoelectric ceramic composition includes a segregation portion positioned in a crystal grain. At least one of Zr or Bi is localized in the segregation portion.

## Description

### Technical Field

The present disclosure relates to a piezoelectric ceramic composition and a piezoelectric actuator.

### Background Art

Piezoelectric ceramic compositions used for actuators, sensors, vibrators, filters, and the like have been known. As lead-free piezoelectric ceramic compositions, various potassium sodium niobate-based compositions have been suggested (for example, PTLs 1 and 2).

### Citation List

### Patent Literature

PTL 1: Japanese Unexamined Patent Application Publication No. 2014-69988
PTL 2: Japanese Unexamined Patent Application Publication No. 2016-219669

### Summary of Invention

According to an aspect of the present disclosure, there is provided a piezoelectric ceramic composition including a potassium sodium niobate-based perovskite type complex oxide represented by Compositional Formula ABO₃, as a main component. Further, the piezoelectric ceramic composition contains Bi in an A site and Zr in a B site. The piezoelectric ceramic composition includes a segregation portion positioned in a crystal grain. At least one of Zr or Bi is localized in the segregation portion.

According to another aspect of the present disclosure, there is provided a piezoelectric actuator including a piezoelectric member that is formed of the piezoelectric ceramic composition, and an electrode that applies a voltage to the piezoelectric member.

### Brief Description of Drawings

[Fig. 1] Fig. 1 is a cross-sectional view schematically showing a piezoelectric ceramic composition according to an embodiment.
[Fig. 2] Fig. 2 is a table showing measurement results of component ratios in the piezoelectric ceramic composition according to an example.
[Fig. 3] Fig. 3 is a table showing measurement results of component ratios in the piezoelectric ceramic composition according to a comparative example.
[Fig. 4] Fig. 4 is a table showing measurement results of compositions and characteristics of a plurality of samples.
[Fig. 5] Fig. 5 is a cross-sectional view showing an example of a piezoelectric actuator.

### Description of Embodiments

### (Main component of piezoelectric ceramic composition)

A piezoelectric ceramic composition according to an embodiment contains a potassium sodium niobate-based (KNN-based, alkali niobate-based) perovskite type complex oxide as a main component. The piezoelectric ceramic composition does not contain, for example, lead (Pb).

The perovskite type complex oxide is represented by simplified Compositional Formula ABO₃. In this compositional formula, the molar ratios of the A site and the B site are respectively 1. Here, this value 1 is not necessarily 1 in a strict sense, but may be considered to denote, for example, a value in a range of 0.5 or greater and 1.4 or less, a value in a range of 0.95 or greater and 1.04 or less, or a value in a range of 0.99 or greater and 1.01 or less.

The expression "perovskite type complex oxide is of a KNN-based" may denote that for example, the A site mainly contains potassium (K) and sodium (Na) and the B site mainly contains niobium (Nb). The expression "A site mainly contains K and Na" may denote that for example, the ratio of the substance amount of K and Na to the substance amount in the A site (molar ratio, for example, 1-w-x-α described below) is 0.7 or greater, 0.8 or greater, or 0.9 or greater. The expression "B site mainly contains Nb" may denote that for example, the ratio of the substance amount of Nb to the substance amount in the B site (molar ratio, for example, (1 - z) × (1 - β) described below) is 0.7 or greater, 0.8 or greater, or 0.9 or greater.

In the present embodiment, the A site contains bismuth (Bi) as a material other than K and Na. For example, the piezoelectric constant can be improved and/or the temperature dependence of the piezoelectric constant can be decreased by allowing the A site to contain Bi.

The A site may or may not contain materials other than K, Na, and Bi. In a case where the A site contains other materials, examples of the materials contained in the A site include silver (Ag), lithium (Li), calcium (Ca), barium (Ba), strontium (Sr), lanthanum (La), cerium (Ce), neodymium (Nd), and/or samarium (Sm). These materials contribute to improvement of the piezoelectric constant and/or improvement of the coercive electric field.

In a case where the A site contains materials other than K, Na, and Bi, the ratio of the substance amount of Bi to the substance amount of the materials other than K and Na in the A site may be appropriately set. For example, the ratio thereof (molar ratio, for example, α/(w + x + α) described below) may be 0.5 or less or greater than 0.5. As shown in the example described below, values appropriate as the value of the piezoelectric constant and the value of the coercive electric field can be obtained in both cases.

In the present embodiment, the B site contains zirconium (Zr) as the material other than Nb. Since the B site contains Zr, for example, the piezoelectric constant can be improved and/or the temperature dependence of the piezoelectric constant can be decreased.

The B site may or may not contain materials other than Nb and Zr. In a case where the B site contains other materials, examples of the materials contained in the B site include antimony (Sb), tantalum (Ta), magnesium (Mg), copper (Cu), zinc (Zn), titanium (Ti), halfnium (Hf), germanium (Ge), tin (Sn), Ce, ytterbium (Yb), iron (Fe), cobalt (Co), nickel (Ni), vanadium (V), and/or tungsten (W). These materials contribute to improvement of the piezoelectric constant and/or improvement the coercive electric field.

In a case where the B site contains materials other than Nb and Zr, the ratio of the substance amount of Zr to the substance amount of the materials other than Nb in the B site (molar ratio, for example, β/(z × (1 - β) + β) described below) may be appropriately set. For example, the ratio thereof may be 0.5 or less or greater than 0.5. As shown in the example described below, values appropriate as the value of the piezoelectric constant and the value of the coercive electric field can be obtained in both cases.

The expression "piezoelectric ceramic compound contains a KNN-based perovskite type complex oxide as a main compound" may denote that for example, the ratio of the mass of the KNN-based perovskite type complex oxide described above to the mass of the piezoelectric ceramic composition is 80% or greater, 90% or greater, or 95% or greater. Alternatively, the expression may denote that, for example, the ratio of the mass of a pure potassium sodium niobate composition represented by (K₁₋ₐNaₐ)NbO₃ to the mass of the piezoelectric ceramic composition is 70% or greater, 80% or greater, or 90% or greater.

### (Segregation portion of Bi and/or Zr)

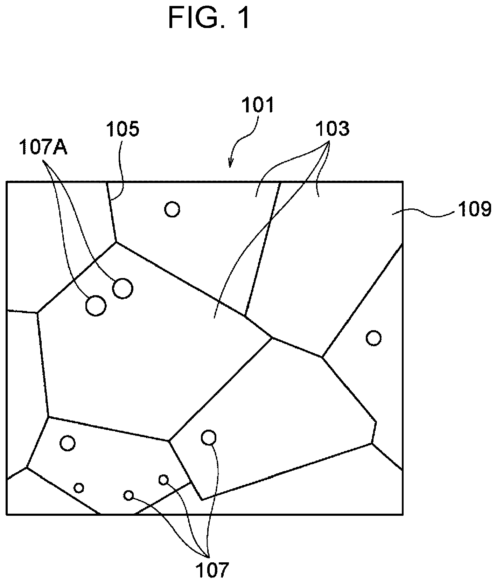

Fig. 1 is a view schematically showing an image (hereinafter, a TEM image) of a cross section of a piezoelectric ceramic composition 101 obtained by using a transmission electron microscope (TEM). This figure schematically shows a range of approximately 5 µm² in an actually obtained image.

When the piezoelectric ceramic composition 101 formed of polycrystals is seen in cross sectional view, a plurality of crystal grains 103 are observed as shown in the figure. Each of the crystal grains 103 is formed of a monocrystal. From another viewpoint, grain boundaries 105 which are the boundaries of the crystal grains 103 are observed.

The piezoelectric ceramic composition 101 according to the present embodiment includes segregation portions 107 where at least one of Bi or Zr is localized, in the crystal grains 103. In such a piezoelectric ceramic composition 101, the electrical resistivity (hereinafter, also simply referred to as "resistivity") is increased (insulating properties are improved) as compared a piezoelectric ceramic composition that does not have segregation portions 107 in the crystal grains 103 as described below.

Further, the piezoelectric ceramic composition 101 may or may not include segregation portions 107 partially or entirely positioned in the grain boundaries 105. However, the description below will be made that the segregation portions 107 are present only in the crystal grains 103. Further, in the description below, portions other than the segregation portions 107 in the crystal grains 103 will also be referred to as non-segregation portions 109.

The segregation portions 107 are visually recognized, for example, as regions whiter than other regions in a TEM image. The boundaries between the segregation portions 107 and other regions are relatively clear in a TEM image, and thus the segregation portions 107 can be visually distinguished from other regions (the range of the segregation portions 107 is specified).

The segregation portion 107 may be defined by the mass percent of Bi and/or Zr (the ratio of the mass of a predetermined element to the mass of all elements). For example, a portion showing the mass percent of Bi that is greater than or equal to a predetermined multiple of the average value in the piezoelectric ceramic composition 101 (including the segregation portions 107, the non-segregation portions 109, and the grain boundaries 105) containing Bi in terms of the mass percent may be defined as the segregation portion 107 where Bi is segregated. Similarly, a portion showing the mass percent of Zr that is greater than or equal to a predetermined multiple of the average value in the piezoelectric ceramic composition 101 containing Zr in terms of the mass percent may be defined as the segregation portion 107 where Zr is segregated. Further, a portion showing the total mass percent of Bi and Zr that is greater than or equal to a predetermined multiple of the average value in the piezoelectric ceramic composition 101 containing Bi and Zr in terms of the total mass percent may be defined as the segregation portion 107 where Bi and Zr are segregated. In the description above, the predetermined multiple or greater may be, for example, 1.1 times or greater, 1.5 times or greater, 2 times or greater, or 10 times or greater. The predetermined multiple may vary between Bi, Zr, and a combination of Bi and Zr.

The mass percents of Bi and Zr can be respectively specified by performing, for example, energy dispersive X-ray spectrometry (EDX) analysis. The average value of the mass percents of Bi and/or Zr can be obtained by specifying the mass percents of the piezoelectric ceramic composition 101 at a plurality of sites and averaging the specified mass percents. The number and the position of the plurality of sites are ideally set such that the average value does not fluctuate due to an increase or a decrease in the number of the plurality of sites. Here, a plurality of 10 or greater or 30 or greater of sites are set in a region of approximately 5 µm² as described in the figure at equal intervals one-dimensionally or two-dimensionally (that is, randomly), and the average value may be acquired from the mass percents thereof in the plurality of sites.

The grain size of the segregation portion 107 may be an appropriate size. For example, a plurality of segregation portions 107 include segregation portions with a grain size of 0.05 µm or greater. The grain size thereof is an equivalent circle diameter and may be calculated based on a cross-sectional image. In the description below, the segregation portion 107 with a grain size of 0.05 µm or greater may also be referred to as a first segregation portion 107A. The number of the segregation portions 107 may be appropriately set. For example, the number of the first segregation portions 107A may be set to 1 or greater or 5 or greater per 5 µm². Further, the area ratio of the segregation portions 107 or the first segregation portions 107A in an optional transverse cross section of the piezoelectric ceramic composition 101 may be, for example 1% or greater.

### (Mass percents of Bi and Zr)

The mass percent of Bi in the segregation portions 107 may or may not be substantially constant regardless of the position. Similarly, the mass percent of Bi in regions (non-segregation portions 109) other than the segregation portions 107 in the crystal grains 103 or in the grain boundaries 105 may or may not be substantially constant regardless of the position. Further, the mass percent of Bi in the non-segregation portions 109 (for example, the average value thereof) and the mass percent of Bi in the grain boundaries 105 (for example, the average value thereof) may be the same as or different from each other. Bi has been described above, but the same applies to Zr.

A difference or a ratio between the mass percent of Bi (for example, the maximum value or the average value) in the segregation portions 107 and the mass percent of Bi (for example, the average value) in the non-segregation portions 109 and/or in the grain boundaries 105 may be appropriately set. For example, the maximum value or the average value of the mass percent of Bi in the segregation portions 107 may be 1.1 times or greater, 1.5 times or greater, 2 times or greater, or 10 times or greater the average value of the mass percent of Bi in the non-segregation portions 109 and/or in the grain boundaries 105. Bi has been described above, but the same may apply to Zr by replacing Bi with Zr and to a combination of Bi and Zr by replacing Bi with Bi and Zr.

The mass percent (for example, the average value) of Bi in the grain boundaries 105 may be less than the mass percent (for example, the average value) of Bi in the non-segregation portions 109. In this case, a difference or a ratio therebetween may be appropriately set. For example, the average value of the mass percent of Bi in the grain boundaries 105 may be 0.95 times or less, 0.9 times or less, or 0.8 times or less the average value of the mass percent of Bi in the non-segregation portions 109. Bi has been described above, but the same may apply to Zr by replacing Bi with Zr and to a combination of Bi and Zr by replacing Bi with Bi and Zr.

### (Specific example of composition of main component)

As described above, the main component of the piezoelectric ceramic composition 101 is a KNN-based perovskite type complex oxide represented by Compositional Formula ABO₃. An example of the formula in which Compositional Formula ABO₃ is specified is shown below. Compositional Formula ABO₃ may also be referred to as, for example, Formula (1).

{K₁₋ᵥNaᵥ)_{1-w-x-α}Li_{w}AgₓAl_{α}}_{y}{(Nb_{1-z}Sb_{z})_{1-β}B1_{β}}O₃ (1)

In Formula (1), the A site contains K, Na, Li, Ag, and A1. The B site contains Nb, Sb, and B1. A1 and B1 are metal elements. v, w, x, y, z, α, and β each represent the molar ratio.

A1 contains at least Bi. A1 may contain only Bi or contain materials other than Bi. In a case where A1 contains materials other than Bi, examples of the materials other than Bi include those that are not specified by Formula (1) among the materials exemplified as the materials in the A site. That is, examples thereof include Ca, Ba, Sr, La, Ce, Nd, and/or Sm.

In the case where A1 contains materials other than Bi, the ratio of the substance amount of Bi to the substance amount of A1 may be appropriately set. For example, the ratio thereof may be 0.7 or greater, 0.8 or greater, or 0.9 or greater. In this case, for example, the same characteristics as the characteristics in the example (described below) in which A1 contains only Bi can be obtained.

B1 contains at least Zr. B1 may contain only Zr or contain materials other than Zr. In a case where B1 contains materials other than Zr, examples of the materials other than Zr include those that are not specified by Formula (1) among the materials exemplified as the materials in the B site. That is, examples thereof include Ta, Mg, Cu, Zn, Ti, Hf, Ge, Sn, Ce, Yb, Fe, Co, Ni, V, and/or W.

In the case where B1 contains materials other than Zr, the ratio of the substance amount of Zr to the substance amount of B1 may be appropriately set. For example, the ratio thereof may be 0.7 or greater, 0.8 or greater, or 0.9 or greater. In this case, for example, the same characteristics as the characteristics in the example (described below) in which B1 contains only Zr can be obtained.

In a case where the A site contains Li, for example, sinterability can be improved. In a case where the A site contains Ag, for example, the phase transition temperature between a tetragon and an orthorhombus can be set to a relatively high temperature (for example, 60°C or higher), and the temperature range where temperature dependence is likely to exhibited as a piezoelectric characteristic can be lowered. In a case where the B site contains Sb, for example, the sinterability can be improved.

As described above, a molar ratio of 1 between A and B in Compositional Formula ABO₃ may not be necessarily 1 in a strict sense and is shown by y in (1). That is, Compositional Formula ABO₃ is not inconsistent with Formula (1). Further, the description has been made that the molar ratio of the B site in Formula (1) is 1, but the molar ratio thereof may not be necessarily 1 in a strict sense. For example, the digit after the decimal point (for example, the third decimal place) to be rounded off at the upper limit and the lower limit of the molar ratio y described below may also be rounded off even at the molar ratio of the B site. That is, a molar ratio of 1 of the B site denotes 1.00 and may also be considered to include 0.995 and 1.004.

The molar ratio y of the A site may be, for example, 0.99 or greater and 1.01 or less (the third decimal place is rounded off). PTLs 1 and 2 describe that in a case where a change in molar ratio of the A site is approximately 0.01, a change in piezoelectric constant is approximately 10% and the piezoelectric characteristics are sufficiently obtained. Therefore, in the present disclosure, the molar ratio y may be considered to be in the above-described range.

As described above, the ratio of the substance amount of K and Na to the substance amount in the A site (1 - w - x - α) is relatively large. Further, the ratio of the substance amount of Nb to the substance amount in the B site ((1 - z) × (1 - β)) is relatively large. On the contrary, the ratio of the substance amount of other elements to the substance amount in the A site or the B site is relatively small. For example, the ratio of the substance amount of elements other than K and Na to the substance amount in the A site (w + x + α) may be 0.3 or less, 0.2 or less, or 0.1 or less. Further, the ratio of the substance amount of elements other than Nb to the substance amount in the B site (z × (1 - β) + β) may be 0.3 or less, 0.2 or less, or 0.1 or less. w, x, z, α, and β may each be 0.1 or less or 0.05 or less.

The ratio between the substance amount of K and the substance amount of Na (1 - v:v) is approximately 1:1. That is, v is approximately 0.5. Here, the substance amount of Na may be greater than the substance amount of K. That is, the piezoelectric ceramic composition may be formed of Na-rich KNN. For example, v may be 0.55 or greater.

A more specific value of the molar ratio in Formula (1) may be appropriately set. Examples thereof include 0.550 ≤ v ≤ 0.625 (the fourth decimal place is rounded off), 0.015 ≤ w ≤ 0.020 (the fourth decimal place is rounded off), 0.0000 ≤ x ≤ 0.0384 (the fifth decimal place is rounded off), 0.99 ≤ y ≤ 1.01 (the third decimal place is rounded off), 0.02 ≤ z ≤ 0.06 (the third decimal place is rounded off), 0.015 ≤ α ≤ 0.020 (the fourth decimal place is rounded off), and 0.03 ≤ β ≤ 0.04 (the third decimal place is rounded off). In combinations of ranges of the molar ratios, the molar ratio values of the example described below are set as the lower limits and the upper limits except for the molar ratio y.

### (Specific examples of sub-components)

The piezoelectric ceramic composition 101 may contain appropriate materials as sub-components other than the main component (KNN-based perovskite type complex oxide). For example, the piezoelectric ceramic composition 101 may further contain Mn. In a case where the piezoelectric ceramic composition 101 contains Mn, for example, the piezoelectric constant can be increased in a wide temperature range.

The addition amount of Mn may be appropriately set. For example, the piezoelectric ceramic composition 101 may contain Mn in an amount of 0.01 parts by mass or greater and 0.50 parts by mass or less or 0.02 parts by mass or greater and 0.03 parts by mass or less in terms of MnO₂ with respect to 100 parts by mass of the main component. In other words, the mass of MnO₂ containing the same mass of Mn as the mass of Mn contained in the piezoelectric ceramic composition 101 may be 0.01 times or greater and 0.50 times or less or 0.02 times or greater and 0.03 times or less the mass of the main component contained in the piezoelectric ceramic composition 101.

The validity of the addition amount described above is described in PTL 1. Further, the addition amount is confirmed to be valid even in a case where the segregation portions 107 are formed in the example described below.

### (Method of producing piezoelectric ceramic composition)

A method of producing the piezoelectric ceramic composition according to the present embodiment may be the same as a known method of producing a potassium sodium niobate-based piezoelectric ceramic composition except for the kinds and the molar ratios of specific metal elements to be added to potassium sodium niobate. The compositional formula of the KNN-based perovskite type complex oxide serving as the main component of the piezoelectric ceramic composition 101 will be described using the aspect represented by Formula (1) as an example and is as follows.

First, powders of compounds (for example, oxides) of the metal elements in Formula (1) are prepared. Examples of such compounds include K₂CO₃, Na₂CO₃, Li₂CO₃, Ag₂O, Nb₂O₅, Sb₂O₃, Bi₂O₃, and ZrO₂. Further, powders of compounds containing sub-components (for example, Mn in the present embodiment) are prepared. Examples of such compounds in a case where the sub-component is Mn include MnO₂.

Next, the powders of the various compounds described above are measured (for example, weighed) to obtain the composition of Formula (1). Further, the powder of the compound of Mn is measured such that the piezoelectric ceramic composition contains 0.01 parts by mass or greater and 0.50 parts by mass or less of Mn with respect to 100 parts by mass of the main component represented by Formula (1) .

Next, the measured powder is mixed in alcohol using a ball mill (wet mixing is performed). For example, ZrO₂ ball may be used as the ball mill. For example, isopropyl alcohol (IPA) may be used as alcohol. The mixing time may be set to, for example, 20 hours or longer and 25 hours or shorter.

Next, the mixture is dried and calcined. The calcination may be performed, for example, at a temperature of 900°C or higher and 1100°C or lower for 3 hours in the atmosphere. Next, the calcined material is crushed with a ball mill. Next, a binder is mixed with the crushed material, and the mixture is granulated. For example, polyvinyl alcohol (PVA) may be used as the binder.

Next, the granulated powder is molded into an optional shape and optional dimensions. The molding pressure may be, for example, 200 MPa. Further, the molded body is sintered, thereby obtaining a piezoelectric ceramic composition. The molded body may be sintered at a temperature of 1000°C or higher and 1250°C or lower for a period of 2 hours or longer and 4 hours or shorter in the atmosphere.

In a case where the piezoelectric ceramic composition is used for a piezoelectric actuator or the like, for example, the piezoelectric ceramic composition may be sintered with conductive paste that is an electrode, and an electrode may be formed after the composition is sintered. Further, the sintered piezoelectric ceramic composition may be subjected to a polarization treatment by applying a voltage with an appropriate magnitude in an appropriate direction.

The segregation portions 107 can be formed by adjusting the sintering temperature in the above-described production method. For example, the segregation portions 107 are formed in a case where the sintering temperature is relatively decreased, and the segregation portions 107 are not formed in a case where the sintering temperature is relatively increased. The specific temperature thereof varies depending on the various conditions such as the specific composition of the piezoelectric ceramic composition 101. As an example, in the compositions of the example and the comparative example described below, the segregation portions 107 are formed in a case where the sintering is performed at 1120°C for 3 hours, and the segregation portions 107 are not formed in a case where the sintering is performed at 1140°C for 3 hours.

### <Example>

### (Effect of segregation portion)

A piezoelectric ceramic composition according to the example which had the segregation portions 107 and a piezoelectric ceramic composition according to the comparative example which had no segregation portion 107 were prepared. Further, it was confirmed that the resistivity was increased (the insulating properties were improved) by the segregation portions based on the comparison between the example and the comparative example. The details are as follows.

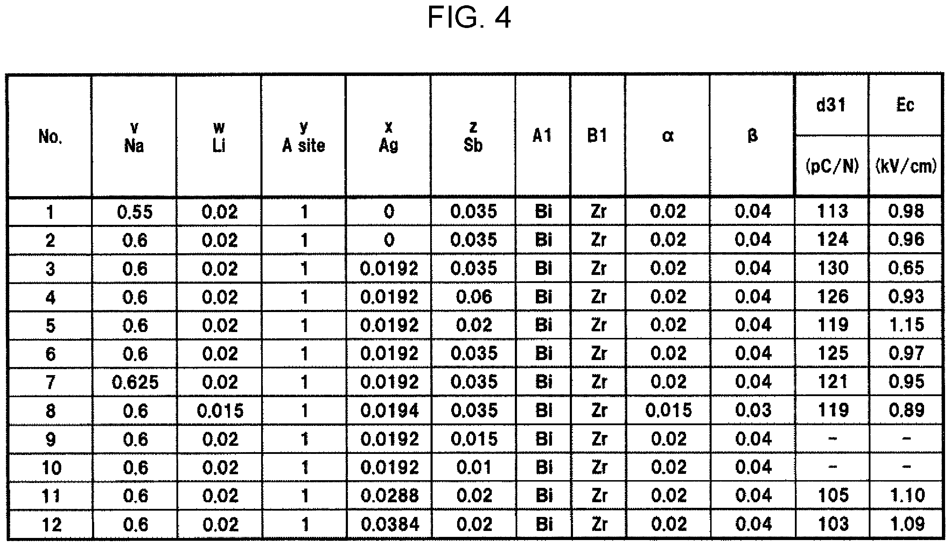

The compositions of the piezoelectric ceramic compositions according to the example and the comparative example were set to be the same as each other. More specifically, both the compositions of the main components of the piezoelectric ceramic compositions according to the example and the comparative example were prepared as represented by Formula (1). The kinds of the materials of A1 and B1 in Formula (1) and the values of v, w, x, y, z, α, and β were set to be identical in the example and the comparative example. Mn was prepared as the sub-component in both the example and the comparative example, and the mass ratio of the sub-component to the main component was set to be identical in both the example and the comparative example, In addition, the piezoelectric ceramic composition according to the example which is referenced here is a piezoelectric ceramic composition of a sample 5 in Fig. 4 described below.

The piezoelectric ceramic composition according to the example was sintered at 1120°C for 3 hours, thereby having segregation portions 107. Meanwhile, the piezoelectric ceramic composition according to the comparative example was sintered at 1140°C for 3 hours, thereby having no segregation portions 107. Here, the presence or absence of the segregation portions 107 is determined by visually observing a TEM image. In the grain sizes of the crystal grains 103 in the example and the comparative example, the average value thereof was 0.4 µm or greater and 0.6 µm or less, the minimum value thereof was 0.1 µm or greater and 0.2 µm or less, the maximum value thereof was 2.0 µm or greater and 3.0 µm or less, and the dispersion thereof was 0.3 or greater and 0.4 or less.

In the piezoelectric ceramic compositions according to the example and the comparative example with the above-described configurations, the piezoelectric constant d₃₁ (pC/N), the coercive electric field (kV/cm), and the resistivity ρ(Ωm) were measured. The piezoelectric constant d₃₁ is a piezoelectric characteristic in a direction orthogonal to the polarization direction when a voltage is applied in the polarization direction of the piezoelectric ceramic composition. A strain generated by the strength of the electric field to be applied or an electric charge generated by the pressure to be applied increases as the value of d₃₁ increases.

The piezoelectric constant d₃₁ was obtained by measuring the polarized piezoelectric ceramic composition in conformity with the standards (EM-4501A, electrical test method for piezoelectric ceramic vibrator) specified by Japan Electronics and Information Technology Industries Association (JEITA). More specifically, the measurement was performed by a resonant-antiresonant method using an impedance analyzer. In the measurement of the coercive electric field, first, an electric flux density D when an electric field of a predetermined waveform (a sine wave, a triangular wave, or the like) was applied to a ferroelectric sample was measured, and a D-E history curve (hysteresis curve) in which an electric field E was expressed by a horizontal axis and the electric flux density D was expressed by the vertical axis was obtained. Further, the intersection between the curve and the horizontal axis was specified as a coercive electric field Ec. The insulation resistance value was calculated by applying a predetermined voltage to the piezoelectric ceramic composition and measuring the leakage current during the application.

The measurement results are as follows.
Example: d₃₁ = 119 (pC/N), Ec = 1.15 (kV/cm), ρ = 1.1 × 10¹¹ (Ωm)
Comparative Example: d₃₁ = 114 (pC/N), Ec = 1.14 (kV/cm), ρ = 9.4 × 10¹⁰ (Ωm)

As described above, the insulating properties of the example were improved as compared with the comparative example. Specifically, the resistivity of the example was 1.1 times or greater and 1.2 times or less the resistivity of the comparative example. Further, the piezoelectric characteristics and the coercive electric field were also slightly improved as compared with the comparative example.

The reason why the insulating properties of the example were further improved than the insulating properties of the comparative example is, for example, as follows. During the sintering, Bi and/or Zr is present relatively abundantly at the grain boundaries formed by grains containing KNN as the main component. In a case where Bi and/or Zr remains at the grain boundaries 105 even after the sintering, the resistivity of the grain boundaries 105 is decreased. As a result, the resistivity of the entire piezoelectric ceramic composition 101 is also decreased. On the contrary, the amount of Bi and/or Zr remaining at the grain boundaries 105 can be relatively decreased by forming the segregation portions 107 of Bi and/or Zr in the crystal grains 103. Further, the resistivity of the entire piezoelectric ceramic composition 101 can be increased.

### (Effect of mass percents of Bi and Zr)

The component ratios in the segregation portions 107, the non-segregation portions 109, and the grain boundaries 105 of the piezoelectric ceramic compositions according to the example and the comparative example described above were respectively measured. In this manner, it was confirmed that the above-described principle that the resistivity is increased by forming the segregation portions 107 is correct.

The component ratio of each portion was measured in the following manner. First, a sample with a size of several micrometers to several tens of micrometers was sampled from the piezoelectric ceramic composition using a focused ion beam (FIB) device. A region with a width of 10 µm and a height of 10 µm was processed to a thickness of 0.12 µm to 0.05 µm from the sampled site. The processed sample was observed with a TEM. JEM-2010F (manufactured by JEOL Ltd.) was used as the TEM. Further, the acceleration voltage was set to 200 kV. In addition, the crystal grains 103 were distinguished from the grain boundaries 105 and the segregation portions 107 were distinguished from the non-segregation portions 109 while the transmission electron image and the scanning TEM (STEM) image were compared with each other. Further, energy dispersive X-ray spectrometry (EDX) analysis was performed on the grain boundaries 105, the segregation portions 107, and the non-segregation portions 109. JED-2300T (manufactured by JEOL Ltd.) was used as a device for EDX.

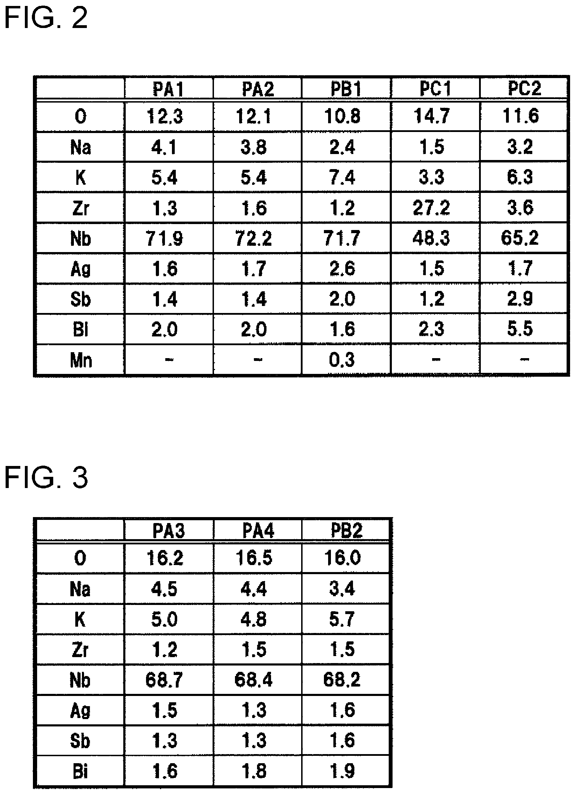

Fig. 2 is a table showing the measurement results of the component ratios in the piezoelectric ceramic composition according to the example. Fig. 3 is a table showing the measurement results of the component ratios in the piezoelectric ceramic composition according to the comparative example.

In each table, the kinds of elements are listed in the leftmost columns. The mass percents of O, Na, K, Zr, Nb, Ag, Sb, Bi, Mn, and Si are listed in the table. Other columns (PA1, PB1, and the like) correspond to various sites in the piezoelectric ceramic composition. Fig. 2 shows the mass percent of each element in five sites of the piezoelectric ceramic composition according to the example. Fig. 3 shows the mass percent of each element in three sites of the piezoelectric ceramic composition according to the comparative example.

PA1 to PA4 correspond to the non-segregation portions 109. PB1 and PB2 correspond to the grain boundaries. PC1 and the PC2 correspond to the segregation portions 107. The reason why the number of columns (PA1 and PA2) corresponding to the non-segregation portions 109 is two in the example is that the component ratios were measured with respect to different positions of the non-segregation portions 109. The same applies to PC1 and PC2, and PA3 and PA4.

The numerical value listed in each cell denotes the mass percent. Further, "-" listed in each cell denotes that a significant amount of mass percent was not measured. The mass percent in each cell is shown such that the second decimal place is rounded off. Due to the effect of the rounding off in each cell, sites where the total mass percent of all elements does not reach 100.0% are also present.

As shown in Fig. 2, the mass percents of Bi and Zr of the segregation portions 107 (PC1 and PC2) are greater than those in other sites. Therefore, it was confirmed that the segregation portions visually recognized as regions whiter than other regions in the TEM image are sites where BI and/or Zr is localized.

Specifically, the mass percent of Bi in the segregation portions 107 is approximately 1.4 times (PC1) the mass percent of Bi or approximately 3.4 times (PC2) the mass percent of Bi in the grain boundaries 105 (PB1). The mass percent of Bi in the segregation portions 107 is approximately 1.2 times (PC1) the mass percent of Bi or approximately 2.8 times (PC2) the mass percent of Bi in the non-segregation portions 109 (PA1 and PA2). Accordingly, it can be said that the mass percent of Bi in the segregation portions 107 is 1.1 times or greater the mass percent of Bi in the non-segregation portions 109 and 1.1 times or greater the mass percent of Bi in the grain boundaries 105.

Further, the mass percent of Zr in the segregation portions 107 is approximately 22.7 times (PC1) the mass percent of Zr or approximately 3.0 times (PC2) the mass percent of Zr in the grain boundaries 105 (PB1). The mass percent of Zr in the segregation portions 107 is approximately 17.0 times or greater (PC1) the mass percent of Zr or approximately 2.3 times or greater (PC2) the mass percent of Zr in the non-segregation portions 109 (PA1 and PA2). Accordingly, it can be said that the mass percent of Zr in the segregation portions 107 is 2.0 times or greater the mass percent of Zr in the non-segregation portions 109 and 2.0 times or greater the mass percent of Zr in the grain boundaries 105.

Further, in the TEM image as shown in Fig. 1, the area ratios of the grain boundaries 105 and the segregation portions 107 are relatively low. Therefore, the above-described ratio of the mass percent of Zr in the segregation portions 107 to the mass percent of Bi and/or Zr in the non-segregation portions 109 may be considered as a ratio of the mass percent of Bi and/or Zr in the segregation portions 107 to the average value of the mass percents of Bi and/or Zr in the piezoelectric ceramic composition (including the grain boundaries 105, the segregation portions 107, and the non-segregation portions 109).

In a case where the mass percent of Bi in the grain boundaries 105 (PB1 and PB2) of the example is compared with the mass percent thereof in the comparative example, the mass percent of Bi of the example is less than the mass percent of Bi of the comparative example. More specifically, the mass percent of Bi in the grain boundaries 105 (PB1) of the example is approximately 0.8 times of the mass percent of Bi in the grain boundaries 105 (PB2) of the comparative example. Similarly, in a case where the mass percent of Zr in the grain boundaries 105 of the example is compared with the mass percent thereof in the comparative example, the mass percent of Zr of the example is less than the mass percent of Zr of the comparative example. More specifically, the mass percent of Zr in the grain boundaries 105 of the example is approximately 0.8 times of the mass percent of Zr in the grain boundaries 105 of the comparative example. In the description above, it was confirmed that the mass percents of Bi and Zr in the grain boundaries 105 are decreased by forming the segregation portions 107.

In a case where the mass percent of Bi in the non-segregation portions 109 (PA1 and PA2) is compared with the mass percent of Bi in the grain boundaries 105 (PB1) in the example, the mass percent of Bi in the grain boundaries 105 is less than the mass percent of Bi in the non-segregation portions 109. More specifically, the mass percent of Bi in the grain boundaries 105 is approximately 0.80 times the mass percent of Bi in the non-segregation portions 109. That is, it can be said that the mass percent of Bi in the grain boundaries 105 is 0.90 times or less or 0.80 times or less the mass percent of Bi in the non-segregation portions. Further, in a case where the mass percent of Bi in the non-segregation portions 109 (PA3 and PA4) is compared with the mass percent of Bi in the grain boundaries 105 (PB2) in the comparative example, the mass percent of Bi in the grain boundaries 105 is greater than the mass percent of Bi in the non-segregation portions 109. In the description above, it was confirmed that the mass percent of Bi in the grain boundaries 105 is further decreased than the mass percent of Bi in the non-segregation portions 109 by forming the segregation portions 107.

Bi has been described, but the same applies to Zr. Specifically, in a case where the mass percent of Zr in the non-segregation portions 109 (PA1 and PA2) is compared with the mass percent of Zr in the grain boundaries 105 (PB1) in the example, the mass percent of Zr in the grain boundaries 105 is less than the mass percent of Zr in the non-segregation portions 109. More specifically, the mass percent of Zr in the grain boundaries 105 is approximately 0.92 times or approximately 0.75 times the mass percent of Zr in the non-segregation portions 109. That is, it can be said that the mass percent of Zr in the grain boundaries 105 is 0.95 times or less the mass percent of Zr in the non-segregation portions 109. Further, in a case where the mass percent of Zr in the non-segregation portions 109 (PA3 and PA4) is compared with the mass percent of Zr in the grain boundaries 105 (PB2) in the comparative example, the mass percent of Zr in the grain boundaries 105 is equal to or greater than the mass percent of Zr in the non-segregation portions 109. In the description above, it was confirmed that the mass percent of Zr in the grain boundaries 105 is further decreased than the mass percent of Zr in the non-segregation portions 109 by forming the segregation portions 107.

### (Example of molar ratio in one example of composition)

The segregation portions 107 can be formed as long as the KNN-based perovskite type complex oxide contains Bi in the A site and Zr in the B site. Therefore, the technique of forming the segregation portions 107 may be applied to various piezoelectric ceramic compositions other than the piezoelectric ceramic composition (piezoelectric ceramic composition containing a complex oxide represented by Formula (1) as a main component) having the composition according to the example described above. It goes without saying that the technique of forming the segregation portions 107 may be applied to the piezoelectric ceramic composition containing a complex oxide represented by Formula (1) as a main component. In this case, the molar ratio value may be appropriately set from the viewpoint of improving the piezoelectric constant and/or the coercive electric field. Hereinafter, an example of the molar ratio value in Formula (1) will be described with reference to the example.

Various samples containing the complex oxide represented by (1) as a main component and having different molar ratio values in Formula (1) were prepared. All samples contained only Mn as the sub-component. Further, the mass of Mn in all samples was set to an amount of 0.25 parts by mass in terms of the mass of MnO₂ with respect to 100 parts by mass of the main component. Further, the piezoelectric constant and the coercive electric field of each sample were measured as the characteristics thereof. The measuring method is as described above.

Fig. 4 is a table showing the measurement results of the compositions and the characteristics of a plurality of samples. In the table, the columns of "No." denote the numbers of samples. Here, the compositions and the characteristics of twelve kinds of samples of samples 1 to 12 are listed in the table.

The columns of "v Na", "w Li", "y A site", "x Ag", "z Sb", "α", and "β" show the values of v, w, y, x, z, α, and β in each sample. The columns of "A1" and "B1" show the kinds of the metal elements of A1 and B1 in each sample. Here, A1 has only Bi and B1 has only Zr as the metal element. The significant digits after the decimal point of the molar ratio are basically identical in a plurality of samples, and the display of 0 at the end is omitted for convenience.

The columns of "d31 pC/N" denote values of piezoelectric constants d₃₁ (pC/N) of the samples. The columns of "Ec kV/cm" denote values of coercive electric fields Ec (kV/cm). Further, "-" listed in each cell denotes that a significant amount of value was not able to be measured.

As shown in the figure, sufficiently high values of the piezoelectric constants and the coercive electric fields were obtained in all samples except for the samples 9 and 10. Specifically, a piezoelectric constant of 103 (pC/N) or greater was obtained, and a coercive electric field of 0.65 (kV/cm) or greater was obtained. Further, the molar ratios z of the samples 9 and 10 were smaller as compared with other samples.

As described above, for example, the range of the molar ratio value in Formula (1) may be set to include the molar ratio values of all samples except for the samples 9 and 10. That is, the lower limits and the upper limits of respective molar ratios may be set by the minimum values and the maximum values of the molar ratios of all samples except for the samples 9 and 10. The range of each molar ratio in this case has been described above, but the range of each molar ratio is repeatedly described by adding the numbers of samples corresponding to the lower limits and the upper limits in parentheses.
0.550 (No. 1) ≤ v ≤ 0.625 (No. 7)
0.015 (No. 8) ≤ w ≤ 0.020 (other than No. 8)
0.0000 (Nos. 1 and 2) ≤ x ≤ 0.0384 (No. 12)
0.02 (Nos. 5, 11, and 12) ≤ z ≤ 0.06 (No. 4)
0.015 (No. 8) ≤ α ≤ 0.020 (other than No. 8)
0.03 (No. 8) ≤ β ≤ 0.04 (other than No. 8)

As described above, the piezoelectric ceramic composition 101 according to the present embodiment is a piezoelectric ceramic composition containing a potassium sodium niobate-based perovskite type complex oxide represented by Compositional Formula ABO₃ as the main component. Further, the piezoelectric ceramic composition 101 contains Bi in the A site and Zr in the B site. Further, the piezoelectric ceramic composition 101 includes segregation portions 107 positioned in the crystal grains 103. At least one of Zr or Bi is localized in the segregation portions 107.

Accordingly, the piezoelectric ceramic composition 101 with a high resistivity can be obtained as described above. As a result, the probability of a short circuit is decreased when, for example, the piezoelectric ceramic composition 101 is applied to a vibration plate 29 or a piezoelectric layer 33 described below. For example, a high resistivity of the piezoelectric ceramic composition 101 which cannot be obtained only by adjusting the composition of the piezoelectric ceramic composition 101 can also be obtained by forming the segregation portions 107 so that the characteristics of the piezoelectric ceramic composition 101 are improved, without changing the composition of the entirety of the piezoelectric ceramic composition 101. Further, the segregation portions 107 can be formed by focusing on the production method and finely adjusting the sintering temperature, and thus the production step is also unlikely to be complicated.

In the present embodiment, the piezoelectric ceramic composition 101 may further contain Mn in addition to the complex oxide as the main component. The complex oxide serving as the main component may be represented by Formula (1). A1 may contain Bi, and B1 may contain Zr. The various molar ratios of Formula (1) may satisfy the above-described inequation. The piezoelectric ceramic composition may contain 0.01 parts by mass or greater and 0.50 parts by mass or less of Mn in terms of MnO₂ with respect to 100 parts by mass of the complex oxide.

In this case, for example, the value of the piezoelectric constant and the value of the coercive electric field are easily increased as described with reference to Fig. 4. As a result, a large driving force is easily generated when, for example, the piezoelectric ceramic composition 101 is applied to a piezoelectric actuator.

Further, in the present embodiment, the mass percent of Bi in the grain boundaries 105 is less than the mass percent of Bi in portions (non-segregation portions 109) other than the segregation portions 107 in the crystal grains 103, and/or the mass percent of Zr in the grain boundaries 105 is less than the mass percent of Zr in the non-segregation portions 109.

That is, in such cases, not only is the mass percent of Bi and/or Zr low in the grain boundaries 105 of the present embodiment in comparison with the grain boundaries 105 of the comparative example, but also the mass percent of Bi and/or Zr is low in comparison with the crystal grains 103 of the present embodiment. Therefore, for example, the effect of improving the resistivity due to a decrease in mass percent of Bi and/or Zr in the grain boundaries 105 described above is likely to be obtained.

Further, in the present embodiment, a plurality of the segregation portions 107 positioned in one or more crystal grains 103 may include first segregation portions 107A having an equivalent circle diameter of 0.05 µm or greater in cross-sectional view. Further, in this case, the piezoelectric ceramic composition 101 may include a plurality of the first segregation portions 107A at a ratio of one or more first segregation portions 107A per 5 µm². Further, the mass percent of Bi in the segregation portions 107 may be 1.1 times or greater the mass percent of Bi in portions (non-segregation portions 109) other than the segregation portions 107 in the crystal grains 103 and may be 1.1 times or greater the mass percent of Bi in the grain boundaries 105, and/or the mass percent of Zr in the segregation portions 107 is 2.0 times or greater the mass percent of Zr in the non-segregation portions 109 and may be 2.0 times or greater the mass percent of Zr in the grain boundaries 105.

It can be said that the segregation portions 107 are sufficiently formed in all cases. Therefore, the effect from the segregation portions 107 described above is likely to be obtained.

### <Application example>

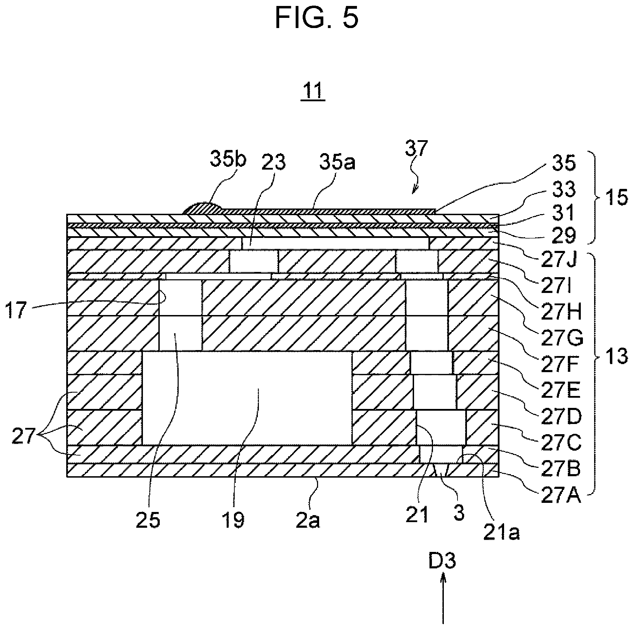

Fig. 5 is a cross-sectional view showing an application example of the piezoelectric ceramic composition. The cross-sectional view shows a part of an ink jet type head 11. The lower part of the paper surface (-D3 side) of Fig. 5 is a side where a recording medium (for example, paper) is disposed.

The head 11 is, for example, an approximately platelike member and has a plurality of configurations shown in Fig. 5 along the plane orthogonal to a D3 axis. The thickness (D3 direction) of the head 11 is, for example, 0.5 mm or greater and 2 mm or less. A plurality of jetting holes 3 (only one jetting hole is provided in Fig. 5) of jetting liquid droplets are opened in a jetting surface 2a facing the recording medium of the head 11. The plurality of jetting holes 3 are two-dimensionally arranged along the jetting surface 2a.

The head 11 is a piezo type head that applies a pressure to a liquid using a mechanical strain of a piezoelectric element and jets liquid droplets. The head 11 includes a plurality of jetting elements 37 each having the jetting hole 3, and one jetting element 37 is shown in Fig. 5. The plurality of jetting elements 37 are two-dimensionally arranged along the jetting surface 2a.

From another viewpoint, the heat 11 includes a platelike flow path member 13 on which a flow path where the liquid (ink) flows is formed, and an actuator substrate 15 (an example of the piezoelectric actuator) that applies a pressure to the liquid in the flow path member 13. The plurality of jetting elements 37 are formed of the flow path member 13 and the actuator substrate 15. The jetting surface 2a is formed of the flow path member 13.

The flow path member 13 includes a common flow path 19 and a plurality of individual flow paths 17 (one individual flow path is provided in Fig. 5) respectively connected to the common flow path 19. Each of the individual flow paths 17 has the jetting hole 3 described above and includes a connection flow path 25, a pressurizing chamber 23, and a partial flow path 21 in order from the common flow path 19 to the jetting holes 3. The pressurizing chamber 23 is opened to the surface of the flow path member 13 on a side opposite to the jetting surface 2a. The partial flow path 21 extends to a side of the jetting surface 2a from the pressurizing chamber 23. The jetting holes 3 are opened to a bottom surface 21a of the partial flow path 21.

The plurality of individual flow paths 17 and the common flow path 19 are filled with the liquid. The liquid is sent to the plurality of partial flow paths 21 from the plurality of pressurizing chambers 23 by changing the volume of the plurality of pressurizing chambers 23 and applying a pressure to the liquid, and a plurality of liquid droplets are jetted from the plurality of jetting holes 3. Further, the plurality of pressurizing chambers 23 are replenished with the liquid from the common flow path 19 via the plurality of the connection flow paths 25.

The flow path member 13 is configured, for example, by laminating a plurality of plates 27A to 27J (hereinafter, A to J may be omitted). The plate 27 is formed with a plurality of holes (mainly through-holes, recesses may also be employed) constituting the plurality of individual flow paths 17 and the common flow path 19. The thickness and the number of laminated plates of the plurality of plates 27 may be appropriately set according to the shape and the like of the plurality of individual flow paths 17 and the common flow path 19. The plurality of plates 27 may be formed of an appropriate material. For example, the plurality of plates 27 may be formed of a metal or a resin. The thickness of the plates 27 is, for example, 10 µm or greater and 300 µm or less.

The actuator substrate 15 has a substantially plate shape having an area over the plurality of pressurizing chambers 23. The actuator substrate 15 is formed of a so-called unimorph type piezoelectric actuator. Further, the actuator substrate 15 may be formed of another type of piezoelectric actuator such as a bimorph type piezoelectric actuator. The actuator substrate 15 includes, for example, the vibration plate 29, a common electrode 31, the piezoelectric layer 33, and an individual electrode 35 in order from a side of the flow path member 13.

The vibration plate 29, the common electrode 31, and the piezoelectric layer 33 extend over the plurality of pressurizing chambers 23 in plan view. That is, these are commonly provided in the plurality of pressurizing chambers 23. The individual electrode 35 is provided fro each pressurizing chamber 23. The individual electrode 35 includes a main body portion 35a overlapping the pressurizing chamber 23 and a lead-out electrode 35b extending from the main body portion 35a. The lead-out electrode 35b contributes to connection with a signal line (not shown).

The piezoelectric layer 33 is, for example, formed of the piezoelectric ceramic composition according to the present embodiment. A portion of the piezoelectric layer 33 sandwiched between the individual electrode 35 and the common electrode 31 is polarized in the thickness direction. Therefore, for example, in a case where an electric field (voltage) is applied to the piezoelectric layer 33 in a polarization direction by the individual electrode 35 and the common electrode 31, the piezoelectric layer 33 is shrunk in a direction along the layer. The shrinkage is regulated by the vibration plate 29. As a result, the actuator substrate 15 is bent and deformed to project to the side of the pressurizing chamber 23. In a case where an electric field (voltage) is applied to the piezoelectric layer 33 in a direction opposite to the above-described direction by the individual electrode 35 and the common electrode 31, the actuator substrate 15 is bent and deformed to a side opposite to the side of the pressurizing chamber 23.

The thickness, the material, and the like of each layer constituting the actuator substrate 15 may be appropriately set. As an example, the thicknesses the vibration plate 29 and the piezoelectric layer 33 are respectively set to 10 µm or greater and 40 µm or less. The thickness of the common electrode 31 may be set to 1 µm or greater and 3 µm or less. The thickness of the individual electrode 35 may be set to 0.5 µm or greater and 2 µm or less. The material of the vibration plate 29 may be a ceramic material with or without piezoelectricity. The material of the common electrode 31 may be a metal material such as an Ag-Pd-based material. The material of the individual electrode 35 may be a metal material such as an Au-based material.

Further, the actuator substrate 15 is an example of the piezoelectric actuator in the description above. The piezoelectric layer 33 is an example of the piezoelectric member. The common electrode 31 and the individual electrode 35 are each an example of the electrode.

The technique of the present disclosure is not limited to the above-described embodiments and may be performed in various forms.

The piezoelectric ceramic composition may be used for a sensor, a vibrator, a filter, and the like in addition to the actuator. The actuator is not limited to being used for an ink jet head and may be used for various devices.

### Reference Signs List

- 101: PIEZOELECTRIC CERAMIC COMPOSITION
- 103: CRYSTAL GRAIN
- 105: GRAIN BOUNDARY
- 107: SEGREGATION PORTION
- 109: NON-SEGREGATION PORTION (IN CRYSTAL GRAIN)
- 15: ACTUATOR SUBSTRATE (PIEZOELECTRIC ACTUATOR)
- 31: COMMON ELECTRODE (ELECTRODE)
- 33: PIEZOELECTRIC LAYER (PIEZOELECTRIC MEMBER)
- 35: INDIVIDUAL ELECTRODE (ELECTRODE)

## Claims

1. A piezoelectric ceramic composition comprising:
a potassium sodium niobate-based perovskite type complex oxide represented by compositional formula ABO₃, as a main component,
wherein the piezoelectric ceramic composition contains Bi in an A site and Zr in a B site, and
a segregation portion is positioned in a crystal grain, and at least one of Zr or Bi is localized in the segregation portion.

2. The piezoelectric ceramic composition according to claim 1, further comprising:
Mn in addition to the complex oxide,
wherein the complex oxide is represented by compositional formula {K₁₋ᵥNaᵥ)_{1-w-x-α}Li_{w}AgₓA1_{α}}_{y}{(Nb_{1-z}Sb_{z})_{1-β}B1_{β}}O₃,
A1 contains Bi,
B1 contains Zr,
the following inequations 0.550 ≤ v ≤ 0.625, 0.015 ≤ w ≤ 0.020, 0.0000 ≤ x ≤ 0.0384, 0.99 ≤ y ≤ 1.01, 0.02 ≤ z ≤ 0.06, 0.015 ≤ α ≤ 0.020, and 0.03 ≤ β ≤ 0.04 are satisfied, and
the piezoelectric ceramic composition contains 0.01 parts by mass or greater and 0.50 parts by mass or less of Mn in terms of MnO₂ with respect to 100 parts by mass of the complex oxide.

3. The piezoelectric ceramic composition according to claim 1 or 2,
wherein a mass percent of Bi at a grain boundary is less than a mass percent of Bi in a portion other than the segregation portion in the crystal grain.

4. The piezoelectric ceramic composition according to any one of claims 1 to 3,
wherein a mass percent of Zr at a grain boundary is less than a mass percent of Zr in a portion other than the segregation portion in the crystal grain.

5. The piezoelectric ceramic composition according to any one of claims 1 to 4,
wherein in a cross-sectional view, a plurality of the segregation portions positioned in one or more crystal grains include first segregation portions having an equivalent circle diameter of 0.05 µm or greater.

6. The piezoelectric ceramic composition according to claim 5,
wherein in the cross-sectional view, a plurality of the first segregation portions are provided at a ratio of one or more of the first segregation portions per 5 µm².

7. The piezoelectric ceramic composition according to any one of claims 1 to 6,
wherein the mass percent of Bi in the segregation portion is respectively 1.1 times or greater the mass percent of Bi in a portion other than the segregation portion in the crystal grain and 1.1 times or greater the mass percent of Bi at the grain boundary.

8. The piezoelectric ceramic composition according to any one of claims 1 to 7,
wherein the mass percent of Zr in the segregation portion is respectively 2.0 times or greater the mass percent of Zr in a portion other than the segregation portion in the crystal grain and 2.0 times or greater the mass percent of Zr at the grain boundary.

9. A piezoelectric actuator comprising:
a piezoelectric member that is formed of the piezoelectric ceramic composition according to any one of claims 1 to 8; and
an electrode that applies a voltage to the piezoelectric member.
